# EUROPEAN PATENT SPECIFICATION

(11) **EP 0 459 836 B1**
(45) Date of publication and mention of the grant of the patent: **17.09.1997**
(21) Application number: 91305013.4
(22) Date of filing: 03.06.1991
(51) Int. Cl.: H01L 21/84, H01L 21/268, H01L 21/203

(54) **Method for fabricating thin-film transistors**
Verfahren zum Herstellen von Dünnfilmtransistoren
Procédé pour fabriquer des transistors à film mince

(30) Priority: 01.06.1990 JP 145069/90
(43) Date of publication of application: 04.12.1991
(73) Proprietor: SEL SEMICONDUCTOR ENERGY LABORATORY CO., LTD., Atsugi-shi Kanagawa-ken 243 (JP)
(72) Inventor: Zhang, Hongyong, Yamamoto-shi, Kanagawa-ken 242 (JP)
(74) Representative: Milhench, Howard Leslie

(56) References cited:
- EP-A- 0 171 509
- EP-A- 0 301 463
- EP-A- 0 331 811
- DE-A- 3 636 221
- US-A- 4 174 217
- Laser annealing of semiconductors, Ed. J.M. Poate et al, Academic Press, 1982

## Description

### FIELD OF THE INVENTION

The present invention relates to a method for fabricating thin-film transistors (referred to hereinafter as TFTs).

### BACKGROUND OF THE INVENTION

Thin-film transistors (TFTs) made with non-single crystal semiconductor materials produced by chemical vapor desposition (referred to hereinafter as CVD) processes or the like have recently become of great interest.

Since such TFTs are deposited on an insulating substrate by a CVD process or the like, the process can advantageously be carried out at a temperature as low as about 500°C or even less. Thus, the process becomes economical, since it allows the use of low-cost soda-lime glass, borosilicate glass, and the like as the substrate.

TFTs are typically field effect transistors which function in a manner similar to so-called MOSFETs (Metal Oxide Silicon Field-Effect Transistors). As mentioned earlier, TFTs can be deposited at low temperature, and moreover, the maximum area thereof is limited only by the dimensions of the deposition apparatus. Thus, TFTs can be freely and easily scaled up with respect to their area, and this is a great advantage. TFTs are, therefore, promising for use as switching devices for active matrix-structured liquid crystal displays consisting of a large number of pixels (picture elements), as well as for one- or two-dimensional image sensors and the like.

TFTs may be subjected to fine patterning using the well-established technology of photolithography, and thus they may be integrated in the same manner as, for example, ICs.

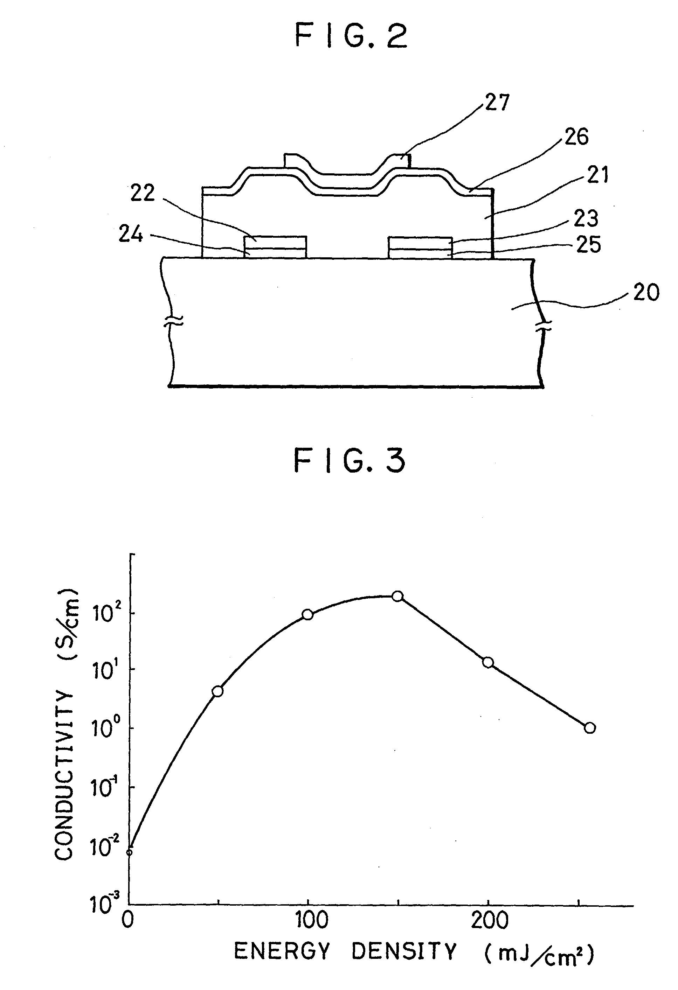

A typical structure of conventional TFTs is schematically shown in Fig. 2 of the accompanying drawings.

As shown in Fig. 2, a typical thin film transistor comprises an insulating glass substrate 20, a thin film semiconductor 21 consisting of non-single crystal semiconductor material, a source region 22, a drain region 23, a source contact 24, a drain contact 25, a gate insulating film 26, and a gate contact 27.

In such TFTs, the current between the source 22 and the drain 23 (the source-to-drain current) can be controlled by applying a voltage to the gate contact 27.

The speed of response of the TFT can be given by the following equation:${\text{S = µ.V/L}}^{\text{2}}$ where, L represents the channel length; µ, the carrier mobility; and V, the gate voltage.

The non-single crystal semiconductor layer used in TFTs comprise numerous grain boundaries and the like, and these have greatly reduced the carrier mobility as compared with that of single crystal semiconductors. The long delay in response ascribed to the low carrier mobility has been a great problem in non-single crystal semiconductor TFTs. TFTs using amorphous silicon (referred to hereinafter as a-Si) semiconductors, in particular, were not practically feasible, since the mobility thereof was so low as in the range of about 0.1 to 1 cm².V⁻¹.sec⁻¹.

In order to overcome such problems it is evident from the equation mentioned earlier that in order to increase the speed of response it is required to shorten the channel length or to increase the carrier mobility and many efforts have been made along these lines. It is particularly effective to seek to reduce the channel length, L, since the speed of response increases in proportion to the reciprocal of the square of L.

In the case of fabricating TFTs on a substrate of large area, however, it is obviously difficult with present photolithographic technology in view of considerations of precision in processing, product yield, production cost, and the like, to reduce the distance between the drain and the source regions (which corresponds approximately to the channel length) to 10 µm or less. In short, no effective means to reduce the channel length of a TFT has yet been established.

With respect to the possibility of increasing the mobility, µ, of the semiconductor layer itself, there have been taken such measures as to incorporate a polycrystalline semiconductor into the active layer of the TFT. This measure requires relatively high temperature.

It is also to be noted that in TFTs, the electric current at the channel portion is subject to the materials of which the source and the drain assemblies are made. Thus, the source and the drain assemblies are often made polycrystalline, or some treatment is applied thereto to assure good electric contact with the channel portion.

More specifically, a thin film of polycrystalline silicon may be deposited by CVD at the source and the drain areas, but the CVD process requires the process to be carried out at a temperature of 500°C or higher. As an alternative process, a treatment may be carried out to assure good contact between the channel portion and the source and the drain. The treatment comprises, after forming semiconductor layers as the drain and the source, introducing therein an n-type or a p-type impurity by ion-implantation, and then heat-treating the drain and the source at a temperature in a range of from 500 to 800°C.

Both of the processes mentioned above require a relatively high temperature to obtain a favorable TFT; no TFTs produced wholly by low temperature processes are yet available.

EP-A-0 171 509 discloses a process to improve the crystallinity of thin semiconductor films by an irradiation step.

EP-A-0 301 463 discloses a conventional TFT obtained by irradiation annealing steps.

Ion implantation is used for obtaining good electric contacts between the channel and the drain and source regions. However, it is extremely difficult to carry out uniform doping of impurities over a large area by ion implantation. This remains a great hindrance to the future development of large-area liquid-crystal displays and the like.

### SUMMARY OF THE INVENTION

With a view to overcoming the problems mentioned earlier, the present invention provides a process according to claim 1 for fabricating TFTs at low temperature, such process comprising crystallizing the channel portion of a TFT, for example by subjecting it to irradiation with an excimer laser, and modifying the electric properties of the source and drain regions of the TFT, for example by subjecting them to irradiation with an excimer laser, independently of the crystallizing of the channel portion. The invention thus provides a two-step laser annealing process for TFTs which is carried out at low temperature.

The above and further features of the invention are set forth with particularity in the appended claims and, together with the advantages thereof, will be well understood from consideration of the following description given with reference to the accompanying drawings.

### BRIEF DESCRIPTION OF THE DRAWINGS

Figs. 1(A) to 1(C) schematically show a process for fabricating a TFT according to an exemplary embodiment of the present invention;
Fig. 2 shows a cross-section of a conventional TFT;
Fig. 3 is a graph showing the relationship between the conductivity of an n-type layer and laser energy density; and
Fig. 4 is a graphical diagram showing relationships between I_{D} and V_{D}.

### DETAILED DESCRIPTION OF THE EMBODIMENT

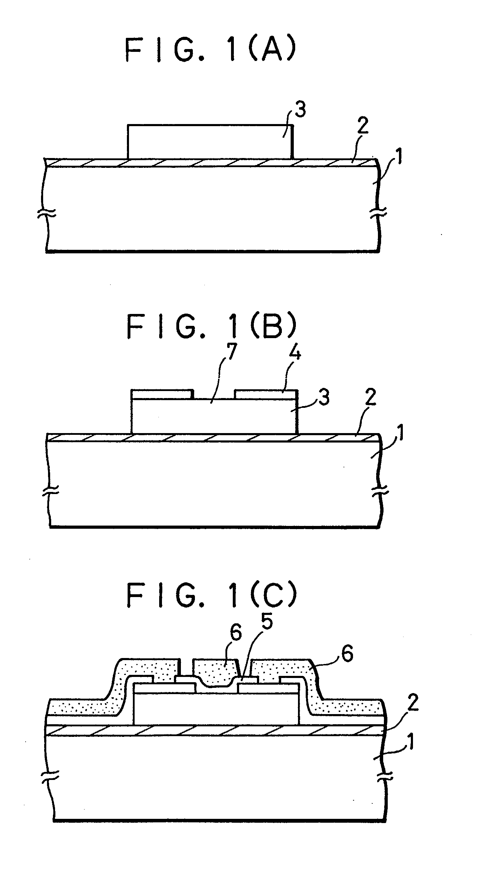

Fig. 1 schematically illustrates a process for fabricating a planar-type TFT according to an exemplary embodiment of the present invention.

On the surface of a soda-lime glass substrate 1 there was deposited a 300 nm thick silicon oxide film serving as a base protective film 2, the film 2 being deposited by a well known sputtering method. The film deposition was carried out under the following conditions:

| | |
|---|---|
| Sputter gas | 100% O₂ |
| Reaction pressure | 0.5 Pa |
| RF power | 400 W |
| Temperature of the substrate | 150°C |
| Rate of film deposition | 5 nm/min. |

On top of the base protective film 2 deposited on the substrate there was further deposited an I-type non-single crystal silicon semiconductor film 3 by means of a well-known sputtering process to a film thickness of approximately 100 nm. The film deposition was carried out under the following conditions:

| | |
|---|---|
| Temperature of the substrate | 100°C |
| Reaction pressure | 0.5 Pa |
| RF power (13.56 MHz) | 300 W. |

Etching under predetermined conditions was then performed, to thereby obtain an intermediate device structure as shown in Fig. 1(A).

Then, the film 3 was annealed by irradiation with excimer laser energy so as to crystallize the film 3 into a polycrystal. The conditions of the annealing process were as follows:

| | |
|---|---|
| Laser energy density | 200 mJ/cm² |
| Pulse repetition | 50 shots. |

Further, on the film 3 there was deposited a 50 nm thick n-type non-single crystal silicon film doped with phosphorus such film serving as a low-resistance non-single crystal semiconductor layer. The deposition of this film was carried out by plasma chemical vapor deposition under the following conditions:

| | |
|---|---|
| Gas materials | SiH₄ + PH₃ + H₂ |
| Reaction pressure | 0.05 Torr |
| Temperature of the substrate | 300°C |
| RF power (13.56 MHz) | 200 W |
| Film thickness | 50 nm. |

A microcrystalline film with a low electric resistance may be deposited as the n-type non-single crystal silicon film, by incorporating a large amount of H₂ gas into the gas materials at elevated RF power.

A portion of the n-type non-single crystal silicon film was then removed using conventional photolithography, leaving the source and the drain areas 4. Thus there was obtained an intermediate device structure as shown in Fig. 1(B).

The n-type non-single crystal semiconductor material of the source and the drain regions 4 was activated by irradiating the same with an excimer laser beam under the following conditions:

| | |
|---|---|
| Laser energy density | 100 mJ/cm² |
| Pulse repetition | 50 shots. |

The channel portion 7 was then activated by plasma treatment in hydrogen under the following conditions:

| | |
|---|---|
| Temperature of the substrate | 250°C |
| RF power | 100 W |
| Duration of the treatment | 60 minutes. |

On the activated channel there were thereafter formed, in the order stated, a 100 nm thick gate oxide film 5, source- and drain- contact holes by etching, and an aluminum contact 6, whereby a TFT structure as shown in Fig. 1(C) was obtained. The formation of the gate oxide film was carried out using the same materials and method as those used in the deposition of the base protective film 2. The etching of the contact holes was carried out by a method well known in the art.

The conductivity of the source and drain n-type non-single crystal semiconductor material 4 changes as a function of the energy density of the irradiating excimer laser beam in the manner shown in Fig. 3.

In Fig. 3, the conductivity of the semiconductor 4 increases with increasing energy density up to 150 mJ/cm². However, the conductivity can be seen to decrease with further increase of the energy density since the N⁺ layer surfaces of the source and drain are damaged by high energy laser irradiation. With still further increase of the energy density, the source and drain semiconductors 4 would sublime.

Therefore, the laser irradiation should be effected at an energy density preferably of 150 mJ/cm² or less, and more preferably in the range of from 100 mJ/cm² to 150 mJ/cm². With laser irradiation with the energy density in the range of from 100 mJ/cm² to 150 mJ/cm², a conductivity in the range of from 80 to 200 S/cm can be obtained.

In case laser beam irradiation with an energy density of 150 mJ/cm² or less is applied, phosphorus impurities contained in the source and drain 4 do not move from the source and drain 4 to the channel portion because with laser irradiation with such a low energy density as 150 mJ/cm² or less, the phosphorus impurities stay in the source and drain 4. Therefore, the channel portion is free from degradation by the phosphorus impurities.

Since the channel portion was well crystallized by the laser annealing of the I-type semiconductor film 3, the channel portion would be degraded by the laser irradiation of the source and drain semiconductors 4 at an energy density of more than 150 mJ/cm² if the channel portion were not masked. The degradation is caused by stress which is, in turn, caused by the difference between the temperature of the channel portion and that of the other portions of the film 3 during the laser irradiation of the source and drain. However, even if the laser irradiation of the intermediate device structure as shown in Fig. 1(B) is carried out without masking the channel portion, this laser irradiation can be applied without degrading the channel portion if a not so high energy density of 150 mJ/cm² or less is applied.

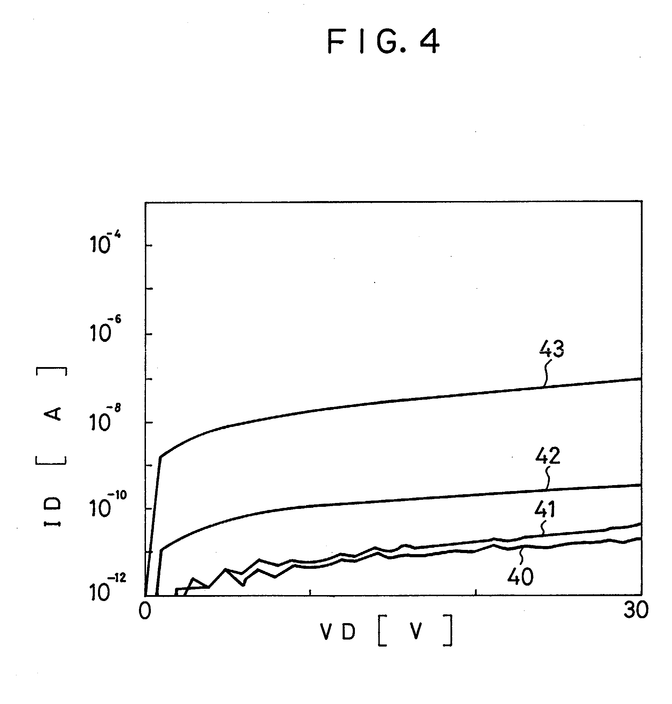

In this connection, in Fig. 4 there is shown the change in the I_{D}-V_{D} characteristics of the TFT as a function of the energy density of the laser beam irradiation at zero gate potential. In the figure, the abscissa represents the source-to-drain voltage, and the ordinate the source-to-drain current; curve 40 shows the I_{D}-V_{D} characteristics for a case without laser beam irradiation of the source and drain semiconductors, and curves 41 to 43 show the I_{D}-V_{D} characteristics for the cases in which source and drain semiconductors were irradiated with a laser beam at an energy of 100 mJ/cm², 150 mJ/cm², and 200 mJ/cm², respectively.

From Fig. 4, it can be seen that the OFF current between the source and drain is small and the channel portion suffers little degradation in the case of the laser irradiation of the source and drain semiconductors at an energy of 150 mJ/cm² or lower.

One might consider crystallizing the I-type semiconductor layer 3 while activating the source and the drain in the same single step by irradiating with a laser beam suitable for both purposes. However, this is not possible because the laser energy density required for the crystallization and that for the activation is different. If the laser beam energy is set to the optimum for the crystallization of the I-type semiconductor layer 3, sublimation of the source and drain n-type semiconductors or damage to the source and drain N⁺ layer or degradation of the channel might occur as explained earlier; if the energy is set to the optimum for the activation, on the other hand, the I-type semiconductor layer 3 would not crystallize. Thus, laser irradiation in two steps becomes crucial for the process according to the present invention.

In the above-described embodiment, the gate insulating film 5 was formed after activation of the n-type source and drain semiconductors 4. In a practical process, however, the order may be reversed.

That is, after depositing the gate insulating film 5, a predetermined pattern etching thereof may be performed thereafter, followed by the activation of the source and the drain areas.

In such a case, the presence of the gate insulating film 5 on the I-type semiconductor film 3 may provide further favourable electric properties to the device since the presence thereof prevents degradation of the channel portion caused by laser irradiation.

Thus, it is clear from the foregoing description that the process according to the present invention enables fabrication of a highly reliable TFT in a low temperature process. The TFT device moreover is of high performance, is furnished with a source and a drain having high electric conductivity, and is less influenced by parasitic resistances.

Furthermore, an excimer laser beam can heat only the surface of a device irradiated therewith. Therefore, the substrate of the device is not subject to thermal damage and also a high density multilayered device can be made by the use of an excimer laser beam.

The process according to the present invention is further advantageous in that the conventional heat treatment at high temperature is omitted. Thus, the process restrains impurities present in the substrate from penetrating into the active layers. This realizes TFTs having long term stability as regards their electric properties.

In the process according to the embodiment of the present invention as set forth earlier, a gate insulating film 5 and a base protective film 2 were provided under the source and the drain contacts 6. Since the same material and the same formation method were used for the films 2 and 5, there is little difference between the coefficients of thermal expansion of the films 2 and 5. Therefore, there is little difference between the thermal expansion of the film 2 and that of the film 5 caused by heat generated during operation of the TFT or by thermal treatments during the fabrication process. Accordingly, there is little risk that a metal electrode, such as an aluminum electrode or the like, provided on the uppermost surface of the device will peel off and become disconnected. Thus, it can be seen that the process according to the present invention provides TFTs which can function for a long period of time with high reliability.

The foregoing description of an exemplary embodiment has been presented for purposes of illustration and description. However, it is to be appreciated that the described embodiment is exemplary only and is susceptible to modification and variation without departure from the scope of the invention as determined by the appended claims. For example, in the embodiment described, a silicon oxide film is used as a gate insulating film (gate oxide film), however, a silicon nitride layer or a multi-layer of silicon oxide and silicon nitride may be used as the gate insulating film instead. An I-type non-single crystal semiconductor film may be an intrinsic semiconductor film or a substantially intrinsic semiconductor film. A substantially intrinsic semiconductor film contains impurities at a concentration less than that of the source and drain n-type semiconductors. An irradiation beam, for example a light beam or a YAG laser beam or the like, may be used for crystallizing the I-type non-single crystal semiconductor film instead of an excimer laser beam. An irradiation beam, for example a light beam or a YAG laser beam or the like, may be used for activating the source and drain n-type semiconductors instead of an excimer laser beam. The light beam may for example be emitted from a halogen lamp or a Xe lamp.

## Claims

1. A method of manufacturing a thin film transistor, said method comprising:
forming a non-single crystal semiconductor layer (3) on a substrate (1);
crystallizing said non-single crystal semiconductor layer (3) by irradiating the same with a first irradiation beam; and
forming source and drain semiconductor layers (4) on the non-single crystal semiconductor layer (3);
characterised in that said method further comprises activating the source and drain semiconductor layers (4) by irradiating the same with a second irradiation beam having an energy density which is less than that of said first irradiation beam.

2. The method of claim 1 wherein the energy density of said second irradiation beam is 150 mJ/cm² or less.

3. The method of any preceding claim wherein the formation of said source and drain semiconductor layers (4) is carried out by forming a semiconductor layer by chemical vapor deposition and patterning said semiconductor layer to define said source and drain semiconductor layers (4).

4. The method of any preceding claim wherein said non-single crystal semiconductor layer (3) comprises an intrinsic or substantially intrinsic semiconductor.

5. The method of any preceding claim wherein said step of forming said source and drain semiconductor layers (4) includes forming a channel region in said non-single crystal semiconductor layer (3).

6. The method of claim 5 wherein the irradiation of said source and drain layers (4) is carried out without masking said channel region.

7. The method of claim 5 further comprising:
forming an insulating film (5) on said channel region and said, source and drain layers (4);
removing portions of said insulating film (5) to form contact openings through said insulating film (5) at said source and drain layers (4); and wherein
said step of activating said source and drain layers (4) includes irradiating said source and drain layers and remaining portions of said insulating film (5) with said remaining portions serving as masks.

8. The method of claim 7 wherein said insulating film (5) comprises silicon oxide, silicon nitride or a multilayer of silicon oxide and silicon nitride.

9. The method of claim 7 or 8 wherein an upper surface of said channel region is entirely covered by said remaining portion.

10. The method of any preceding claim wherein said source and drain layers comprise n-type semiconductor material.

11. The method of any preceding claim wherein irradiation is effected by use of a laser beam and/or a light beam.

## Patentansprüche

1. Verfahren zur Herstellung eines Dünnschichttransistors, bei dem
auf einem Substrat (1) eine Halbleiterschicht aus einem Nicht-Einkristall gebildet wird,
die Halbleiterschicht (3) aus Nicht-Einkristall mittels Bestrahlung mit einem ersten Strahl kristallisiert wird und
auf die Halbleiterschicht (3) aus Nicht-Einkristall Source- und Drain-Halbleiterschichten (4) gebildet werden,
**dadurch gekennzeichnet,** daß
die Source- und Drain-Halbleiterschichten (4) mittels Bestrahlung mit einem zweiten Strahl einer geringeren Energiedichte als der erste Strahl aktiviert werden.

2. Verfahren nach Anspruch 1, **dadurch gekennzeichnet**, daß die Energiedichte des zweiten Strahls 150 mJ/cm² oder weniger beträgt.

3. Verfahren nach einem der vorhergehenden Ansprüche, **dadurch gekennzeichnet**, daß die Source- und Drain-Halbleiterschichten (4) durch Ausbildung einer Halbleiterschicht mittels Chemical Vapor Deposition und durch Strukturierung der Halbleiterschicht zu Source- und Drain-Halbleiterschichten (4) gebildet werden.

4. Verfahren nach einem der vorhergehenden Ansprüche, **dadurch gekennzeichnet**, daß die Halbleiterschicht (3) aus Nicht-Einkristall einen Eigenhalbleiter oder einen im wesentlichen eigenleitenden Halbleiter umfaßt.

5. Verfahren nach einem der vorhergehenden Ansprüche, **dadurch gekennzeichnet**, daß bei der Bildung der Source- und Drain-Halbleiterschichten (4) ein Kanalbereich in der Halbleiterschicht (3) aus Nicht-Einkristall gebildet wird.

6. Verfahren nach Anspruch 5, **dadurch gekennzeichnet**, daß die Bestrahlung der Source- und Drain-Schichten (4) ohne Maskierung des Kanalbereichs vorgenommen wird.

7. Verfahren nach Anspruch 5, bei dem
auf den Kanalbereich und auf die Source- und Drain-Schichten (4) eine dünne Isolationsschicht (5) aufgebracht wird,
Bereiche der dünnen Isolationsschicht (5) zur Bildung von durch die dünne Isolationsschicht (5) hindurch reichenden Kontaktöffnungen auf den Source- und Drain-Schichten (4) abgetragen werden, und bei dem
bei der Aktivierung der Source- und Drain-Schichten (4) diese sowie die verbleibenden Bereiche der dünnen Isolationsschicht (5) bestrahlt werden, wobei die verbleibenden Bereiche als Maske dienen.

8. Verfahren nach Anspruch 7, **dadurch gekennzeichnet**, daß die dünne Isolationsschicht (5) Siliziumoxid, Siliziumnitrid oder eine Mehrfachschicht aus Siliziumoxid und Siliziumnitrid umfaßt.

9. Verfahren nach Anspruch 7 oder 8, **dadurch gekennzeichnet**, daß eine obere Oberfläche des Kanalbereichs vollständig durch die verbleibenden Bereiche bedeckt ist.

10. Verfahren nach einem der vorhergehenden Ansprüche, **dadurch gekennzeichnet**, daß die Source- und Drain-Schichten halbleitendes Material vom n-Leitfähigkeitstyp umfassen.

11. Verfahren nach einem der vorhergehenden Ansprüche, **dadurch gekennzeichnet,** daß die Bestrahlung durch Verwendung eines Laserstrahls und/oder eines Lichtstrahls vorgenommen wird.

## Revendications

1. Procédé pour fabriquer un transistor à film mince, ledit procédé comprenant :
la formation d'une couche (3) de semi-conducteur non monocristallin sur un substrat (1) ;
la cristallisation de ladite couche (3) de semi-conducteur non monocristallin par irradiation de celle-ci par un premier faisceau d'irradiation ; et
la formation de couches (4) de semi-conducteur de source et de drain sur la couche (3) de semi-conducteur non monocristallin ;
caractérisé en ce qu'il comprend en outre l'activation des couches (4) de semi-conducteurs de source et de drain en les irradiant par un second faisceau d'irradiation ayant une densité d'énergie qui est inférieure à celle dudit premier faisceau d'irradiation.

2. Procédé selon la revendication 1, dans lequel la densité d'énergie dudit second faisceau d'irradiation est égale ou inférieure à 150 mJ/cm².

3. Procédé selon l'une quelconque des revendications précédentes, dans lequel la formation desdites couches (4) de semi-conducteurs de source et de drain est effectuée en formant une couche de semi-conducteur par dépôt en phase gazeuse par procédé chimique, et en configurant ladite couche de semi-conducteur pour définir lesdites couches (4) de semi-conducteurs de source et de drain.

4. Procédé selon l'une quelconque des revendication précédentes, dans lequel ladite couche (3) de semi-conducteur non monocristallin comprend un semi-conducteur intrinsèque ou pratiquement intrinsèque.

5. Procédé selon l'une quelconque des revendications précédentes, dans lequel ladite opération de formation desdites couches (4) de semi-conducteur de source et de drain comprend la formation d'une région de canal dans ladite couche (3) de semi-conducteur non monocristallin.

6. Procédé selon la revendication 5, dans lequel l'irradiation desdites couches (4) de source et de drain est effectuée sans masquer ladite région de canal.

7. Procédé selon la revendication 5, comprenant en outre :
la formation d'un film isolant (5) sur ladite région de canal et sur lesdites couches (4) de source et de drain ;
l'élimination des parties dudit film isolant (5) pour former des ouvertures de contact à travers ledit film isolant (5) sur lesdites couches (4) de source et de drain; et dans lequel
ladite opération d'activation desdites couches (4) de source et de drain comprend l'irradiation desdites couches de source et de drain et des parties restantes dudit film isolant (5), lesdites parties restantes servant de masques.

8. Procédé selon la revendication 7, dans lequel ledit film isolant (5) comprend de l'oxyde de silicium, du nitrure de silicium ou plusieurs couches d'oxyde de silicium et de nitrure de silicium.

9. Procédé selon la revendication 7 ou 8, dans lequel une surface supérieure de ladite région de canal est entièrement recouverte par ladite partie restante.

10. Procédé selon l'une quelconque des revendications précédentes, dans lequel lesdites couches de source et de drain comprennent un matériau semi-conducteur de type n.

11. Procédé selon l'une quelconque des revendications précédentes, dans lequel l'irradiation est effectuée en employant un faisceau laser et/ou un faisceau lumineux.
